# EUROPÄISCHE PATENTSCHRIFT

(11) **EP 0 714 124 B1**
(45) Veröffentlichungstag und Bekanntmachung des Hinweises auf die Patenterteilung: **29.01.2003**
(21) Anmeldenummer: 95117633.8
(22) Anmeldetag: 06.11.1995
(51) Int. Cl.: H01L 21/98, H01L 25/065, C23C 16/18

(54) **Verfahren zur Befestigung eines ersten Substrates auf einem zweiten Substrat und Verwendung des Verfahrens zur Herstellung einer dreidimensionalen Schaltungsanordnung**
Method for bonding a first substrate to a second substrate and application of the method to the fabrication of a three dimensional circuit device
Procédé pour relier un premier substrat à un deuxième substrat et application du procédé pour fabriquer un dispositif de circuit tridimensionnel

(30) Priorität: 17.11.1994 DE 4440982
(43) Veröffentlichungstag der Anmeldung: 29.05.1996
(73) Patentinhaber: Infineon Technologies AG, 81669 München (DE)
(72) Erfinder: Pamler, Werner, Dr., D-80686 München (DE); Schwarzl, Siegfried, Dr., D-85579 Neubiberg (DE)
(74) Vertreter: Banzer, Hans-Jörg, Dipl.-Ing.

(56) Entgegenhaltungen:
- EP-A- 0 610 709
- US-A- 5 170 930
- US-A- 5 192 835
- US-A- 5 196 372
- KAZUO TSUBOUCHI ET AL: "AREA-SELECTIVE CVD OF METALS" THIN SOLID FILMS, Bd. 228, Nr. 1 / 02, 15.Mai 1993, Seiten 312-318, XP000381100
- FRAAS L M ET AL: "EPITAXIAL GROWTH FROM ORGANOMETALLIC SOURCES IN HIGH VACUUM" JOURNAL OF VACUUM SCIENCE AND TECHNOLOGY: PART B, Bd. B04, Nr. 1, 1.Januar 1986, Seiten 22-29, XP000560637
- HAYASHI Y ET AL: "FABRICATION OF THREE-DIMENSIONAL IC USING "CUMULATIVELY BONDED IC" (CUBIC) TECHNOLOGY" SYMPOSIUM ON VLSI TECHNOLOGY, HONOLULU, JUNE 4 - 7, 1990, Nr. SYMP. 10, 4.Juni 1990, INSTITUTE OF ELECTRICAL AND ELECTRONICS ENGINEERS, Seiten 95-96, XP000164428
- PATENT ABSTRACTS OF JAPAN vol. 012, no. 406 (P-777), 27.Oktober 1988 & JP 63 144242 A (DAINIPPON PRINTING CO LTD), 16.Juni 1988,
- PATENT ABSTRACTS OF JAPAN vol. 013, no. 472 (C-647), 25.Oktober 1989 & JP 01 184278 A (FUJITSU LTD), 21.Juli 1989,

## Beschreibung

Bei verschiedenen technischen Anwendungen müssen Substrate fest miteinander verbunden werden. So werden zum Beispiel bei der Chipmontage vereinzelte Halbleiterchips auf Trägern oder Wärmesenken befestigt.

Eine weitere Anwendung tritt bei der kubischen Integration auf. Dabei werden Substrate, die integrierte Schaltungen, Sensorstrukturen oder ähnliches enthalten, die aus unterschiedlichen Substratmaterialien bestehen können und/oder in unterschiedlichen Technologien gefertigt sein können, jeweils bis auf wenige 10 µm dünn geschliffen und als Stapel, auch Stack genannt, angeordnet. In senkrechter Richtung werden Kontakte gebildet, über die die Schaltungsstrukturen in den verschiedenen Substraten miteinander verbunden werden. Ein solcher Bauelementstapel erscheint von außen betrachtet als neuer Halbleiterbaustein. Die benachbarten Substrate im Stapel müssen untereinander fest miteinander verbunden werden. Dabei müssen auch Verbindungen zwischen aufeinandertreffenden Kontakten benachbarter Substrate gebildet werden.

In der europäischen Patentanmeldung EP 0 610 709 A ist vorgeschlagen zur Verbindung und Durchkontaktierung von Substraten in einer dreidimensionalen Schaltungsanordnung eine hochschmelzende intermetallische Phase zu verwenden. Diese intermetallische Phase wird aus einem Gemisch aus zwei Metallkomponenten gebildet, von denen bei der Verarbeitungstemperatur die eine flüssig und die andere fest ist und von denen sich die feste Komponente in der flüssigen Komponente löst, was zur Aushärtung des Gemisches führt. Bei Überschreitung der Solidus-Kurve im Phasendiagramm hat sich das Gemisch vollständig verfestigt. Im deutschen Sprachgebrauch wird eine solche intermetallische Phase als Amalgam bezeichnet, sofern die flüssige Komponente aus Quecksilber besteht. In dem vorgeschlagenen Verfahren ist die flüssige Komponente jedoch nicht auf Quecksilber beschränkt. Sie kann insbesondere aus Quecksilber, Gallium oder Indium bestehen. Das Gemisch wird in Vertiefungen eingebracht, die jeweils in benachbarten Substraten erzeugt werden und die beim Zusammenfügen der Substrate aufeinandertreffen. Die Vertiefungen werden mit der flüssigen Komponente aufgegossen. Überschüssiges Material wird durch Abschütteln oder in einem elektromagnetischen Wechselfeld entfernt. Nachteiligerweise kann dabei das Gemisch in den Vertiefungen auch vor dem Zusammenfügen der Substrate aushärten.

Der Erfindung liegt das Problem zugrunde, ein weiteres Verfahren zur Befestigung eines ersten Substrates auf einem zweiten Substrat unter Verwendung einer hochschmelzenden intermetallischen Phase anzugeben, das insbesondere zur Herstellung einer dreidimensionalen Schaltunganordnung geeignet ist, mit geringem Aufwand durchführbar ist und bei dem das Herstellen der Verbindung zwischen den Substraten sicher gesteuert werden kann.

Dieses Problem wird erfindungsgemäß gelöst durch ein Verfahren gemäß Anspruch 1. Weitere Ausgestaltungen der Erfindung gehen aus den übrigen Ansprüchen hervor.

In dem erfindungsgemäßen Verfahren wird als bei der Verarbeitungstemperatur flüssige Metallkomponente Gallium verwendet. Gallium weist einen Schmelzpunkt von 29,8°C auf. Das Gallium wird in dem erfindungsgemäßen Verfahren durch selektive Abscheidung auf elektrisch leitfähigen Strukturen aufgebracht, die von isolierenden Strukturen aus dielektrischem Material umgeben sind. Die elektrisch leitfähigen Strukturen können dabei aus Metall, Metallsilizid oder dotiertem Silizium bestehen.

Die Abscheidung des Galliums erfolgt aus der Gasphase unter Verwendung einer metallorganischen Verbindung. Als metallorganische Verbindung wird dabei insbesondere Trialkylgallium mit der chemischen Formel Ga(CₙH₂ₙ₊₁)₃, wobei n eine ganze Zahl größer Null ist, verwendet. Trialkylgallium, insbesondere Trimethylgallium sowie Triethylgallium sind als Ausgangsmaterialien zur Herstellung von III-V-Halbleiterschichten in CVD-Verfahren bekannt (siehe L. M. Fraas et al, J. Vac. Sci. Technol. B4(1), 1986, Seiten 22 bis 29). Die Erfindung macht sich die Beobachtung zunutze, daß mit diesen Ausgangsmaterialien sich Ga nicht auf Isolatorschichten abscheidet.

Desweiteren kann als metallorganische Verbindung Dimethylgalliumhydrid zusammen mit Wasserstoff verwendet werden. Dabei lagert sich der Wasserstoff an der ersten Hauptfläche an. An der Oberfläche der elektrisch leitfähigen Strukturen kommt es unter katalytischer Wirkung freier Elektronen aus der elektrisch leitfähigen Struktur zu einer Reaktion der CH₃-Gruppe und dissoziiertem Wasserstoff zu CH₄, das flüchtig ist. Da an der Oberfläche isolierender Strukturen aus dielektrischem Material diese freien Elektronen nicht zur Verfügung stehen, scheidet sich Gallium selektiv auf der Oberfläche der elektrisch leitfähigen Strukturen ab. Der Wasserstoff kann als Prozeßgas zugegeben werden oder durch eine Oberflächenbehandlung mit wäßriger Flußsäure (HF:H₂O) und destilliertem Wasser vor der Abscheidung als Oberflächenbelegung auf die erste Hauptfläche aufgebracht werden. Sobald die Oberfläche der elektrisch leitfähigen Strukturen mit einer ersten Schicht von Galliumatomen bedeckt ist, lagert sich an deren Oberfläche bei der Abscheidereaktion freiwerdender Wasserstoff an, so daß die Reaktion weiter verläuft. Ein ähnliches Modell für die selektive Abscheidung von Aluminium wurde von K. Tsubouchi et al, Thin solid films, Bd. 228 (1993), Seiten 312 bis 318 vorgeschlagen.

Als Metall, mit dem das Gallium vermischt wird unter Bildung einer intermetallischen Phase, wird vorzugsweise Nickel oder Kupfer verwendet. Eine intermetallische Phase mit Gallium und 35 Gewichtsprozent Nickel weist einen Schmelzpunkt von 895°C auf. Eine intermetallische Phase aus Gallium und Kupfer mit 55 Gewichtsprozent Kupfer weist einen Schmelzpunkt von 485°C auf.

Es ist ein wesentliches Merkmal der Erfindung, auf der zweiten Hauptfläche des zweiten Substrats, die beim Zusammenfügen der Substrate der ersten Hauptfläche des ersten Substrats zugewandt ist, Metallstrukturen zu erzeugen aus dem Metall, das zur Bildung der intermetallischen Phase verwendet wird. In diesem Fall werden die elektrisch leitfähigen Strukturen, auf die das Gallium abgeschieden wird, vorzugsweise aus einem Metall gebildet, das mit Gallium keine intermetallische Phase bildet, zum Beispiel Wolfram oder Aluminium, das auch die Standardmetallisierung in der Mikroelektronik darstellt. Dies hat den Vorteil, daß ein vorzeitiges Reagieren zwischen Gallium und dem Metall zu der intermetallischen Phase unterdrückt wird. Damit ist sichergestellt, daß die Reaktion zur Ausbildung der intermetallischen Phase erst einsetzt, wenn die beiden Substrate zusammengefügt sind.

Die leitfähigen Strukturen können alternativ auch mit einer dünnen Nickel- oder Kupferschicht belegt sein. Die Schichtdicke wird dabei so bemessen, daß nur ein Teil des aufgebrachten Galliums in der hier ablaufenden Reaktion verbraucht wird. Auf diese Weise wird eine besonders gute mechanische Haftung der beiden Substrate erzielt.

Das Verfahren ist geeignet zur Befestigung von vereinzelten Bauelementen auf Wärmesenken oder Trägern.

Das Verfahren ist besonders vorteilhaft einsetzbar zur Herstellung einer dreidimensionalen Schaltungsanordnung. Dazu werden mehrere Substrate, die im Bereich einer Oberseite Schaltungsstrukturen umfassen und die von der Rückseite gedünnt werden, zum Beispiel auf wenige 10 um, als Stapel zusammengefügt und fest miteinander verbunden. Dazu werden zwischen benachbarten Substraten feste Verbindungen aus der intermetallischen Phase gebildet, die sich bei der Durchmischung von Gallium und Metall bildet. Das Gallium wird dazu jeweils selektiv auf einer elektrisch leitenden Struktur auf einem der Substrate abgeschieden. Das zur Durchmischung erforderliche Metall ist auf dem anderen Substrat als Metallstruktur aufgebracht. Elektrisch leitende Strukturen können Kontakte sein, die in dem jeweiligen Substrat an die Hauptfläche angrenzen, oder außerhalb der Kontakte, isoliert von den Kontakten, aufgebrachte zusätzliche Flächen.

Vorzugsweise ist das hinzuzufügende zweite Substrat mit einer entsprechenden Anordnung von Kontakten und Metallflächen versehen. Zwischen den elektrisch leitfähigen Strukturen ist jeweils dielektrisches Material, zum Beispiel SiO₂, einer Planarisierungsschicht, vorhanden. In einer auf diese Weise hergestellten Schaltungsstruktur sind aufeinandertreffende Kontakte elektrisch und mechanisch miteinander verbunden. Aufeinandertreffende zusätzliche Metallflächen dienen der mechanischen Verbindung sowie der Wärmeableitung aus der dreidimensionalen Schaltungsanordnung. Eine Isolation zwischen Kontakten und Metallflächen ist durch die dazwischen angeordnete isolierende Struktur aus dielektrischem Material und durch die selektive Galliumabscheidung auf der Oberfläche der elektrisch leitenden Strukturen gewährleistet.

Im folgenden wird die Erfindung anhand eines Ausführungsbeispiels und der Figuren näher erläutert.
- Figur 1: zeigt ein erstes Substrat, das im Bereich einer ersten Hauptfläche elektrisch leitfähige Strukturen und isolierende Strukturen aus dielektrischem Material umfaßt, nach der selektiven Abscheidung von Gallium auf die Oberfläche der elektrisch leitfähigen Strukturen.
- Figur 2: zeigt das erste Substrat nach dem Zusammenfügen mit einem zweiten Substrat und Ausbildung einer intermetallischen Phase zur festen Verbindung zwischen beiden Substraten.

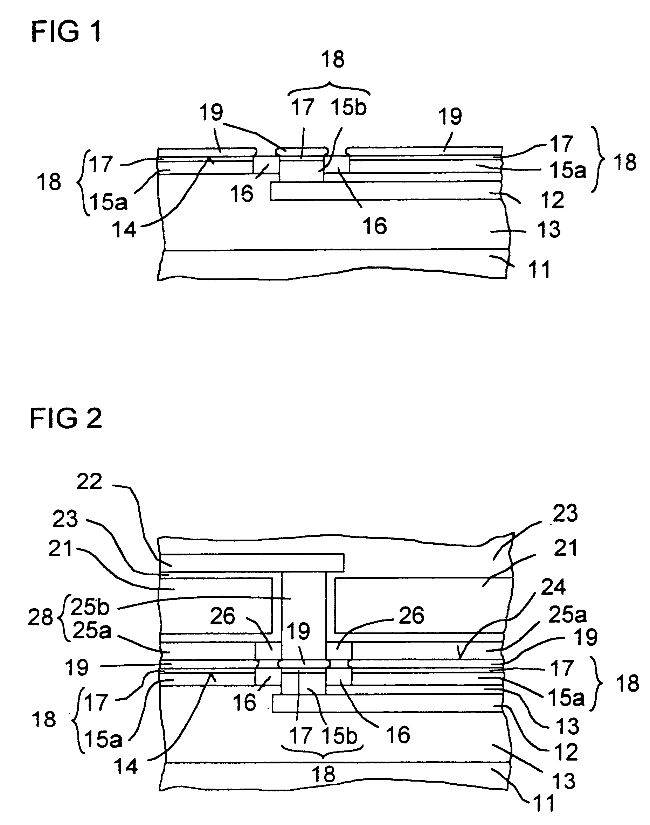

Ein erstes Substrat 11, das zum Beispiel eine Halbleiterscheibe aus einkristallinem Silizium oder einem III-V-Halbleiter oder ein vereinzelter Chip aus einer solchen Halbleiterscheibe ist, umfaßt Schaltungsstrukturen, die Bestandteil einer mikroelektronischen Schaltung oder einer optoelektronischen Komponente oder einer Sensorkomponente sind (siehe Figur 1). Die Schaltungsstrukturen, die im einzelnen in Figur 1 nicht dargestellt sind, umfassen mindestens eine Metallisierungsebene 12, die durch eine SiO₂-Schicht 13 gegenüber dem Substrat 11 isoliert ist. Im Bereich einer ersten Hauptfläche 14 umfaßt das Substrat 11 elektrisch leitfähige Strukturen 15 sowie isolierende Strukturen 16.

Die elektrisch leitfähigen Strukturen 15 umfassen Metallflächen 15a, die auf der Oberfläche der SiO₂-Schicht 13 angeordnet sind und Kontakte 15b, die auf die Oberfläche der Metallisierungsebene 12 reichen. Die Metallflächen 15a und die Kontakte 15b werden aus einem Metall, zum Beispiel Aluminium oder Wolfram gebildet. Auf die Oberfläche der Metallflächen 15a sowie der Kontakte 15b auf der Oberfläche der Metallflächen 15a sowie der Kontakte 15b ist jeweils eine leitfähige Schicht 17 angeordnet. Die leitfähige Schicht 17 weist eine Dicke von zum Beispiel 100 nm auf und wird aus Nickel oder Kupfer gebildet. Die Metallflächen 15a und die darauf angeordnete leitfähige Schicht 17 sowie die Kontakte 15b mit der darauf angeordneten leitfähigen Schicht 17 bilden gemeinsam elektrisch leitfähige Strukturen 18. Die elektrisch leitfähigen Strukturen 18 können auch durchgehend aus einem Material gebildet werden. Zwischen je zwei elektrisch leitfähigen Strukturen 18 ist eine der isolierenden Strukturen 16 angeordnet. Die isolierenden Strukturen 16 bestehen zum Beispiel aus SiO₂, Si₃N₄ oder ähnlichem.

Durch Abscheidung aus der Gasphase (CVD) wird selektiv auf die Oberfläche der elektrisch leitfähigen Strukturen 18 Gallium 19 abgeschieden. Das Gallium 19 wird in einer Dicke von zum Beispiel 0,5 µm abgeschieden.

Die Abscheidung wird zum Beispiel unter Verwendung eines Trimethylgallium enthaltenden Prozeßgases im Druckbereich 1 bis 5 Torr (1,33 bis 6,65 hPa) mit einem Partialdruck des Trimethylgalliums von etwa 1 bis 10 mTorr (0,13 bis 1,3 Pa) und im Temperaturbereich von 350 bis 500°C durchgeführt.

Alternativ kann zur Abscheidung des Galliums 19 in dem CVD-Verfahren ein Triethylgallium enthaltendes Prozeßgas verwendet werden und die Abscheidung im Druckbereich von 1 bis 5 Torr (1,33 bis 6,65 hPa) mit einem Partialdruck von Triethylgallium von 1 bis 10 mTorr (0,13 bis 1,3 Pa) und im Temperaturbereich von 350 bis 500°C durchgeführt werden.

Schließlich kann das Gallium 19 unter Verwendung von Dimethylgalliumhydrid Ga(CH₃)₂H und H₂ abgeschieden werden. Dazu wird vor der CVD-Abscheidung die erste Hauptfläche 14 mit wäßriger Flußsäure gereinigt. Das Verhältnis HF:H₂O beträgt dabei 1:50 bis 1:100. Anschließend wird die erste Hauptfläche 14 etwa 10 Minuten in destilliertem Wasser gespült. Durch diese Vorbehandlung bildet sich an der ersten Hauptfläche 14 eine H₂-Belegung. Die erste Hauptfläche 14 wird zur Abscheidung auf eine Temperatur im Bereich 200 bis 350°C geheizt. An der geheizten Oberfläche der elektrisch leitfähigen Strukturen 18 dissoziiert der Wasserstoff H₂ unter katalytischer

Mitwirkung von freien Elektronen, die in den elektrisch leitfähigen Strukturen 18 zur Verfügung stehen, zu atomarem Wasserstoff H. Die Abscheidung erfolgt über die Reaktion

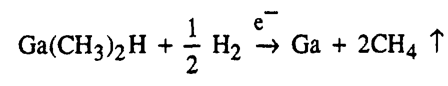

Die Abscheidung erfolgt im Druckbereich von 1 bis 5 Torr (1,33 bis 6,65 hPa) , wobei der Partialdruck von Dimethylgalliumhydrid 1 bis 10 mTorr (0,13 bis 1,3 Pa) beträgt. Der Temperaturbereich für die Abscheidung liegt bei 200 bis 350°C.

Anschließend wird das erste Substrat 11 mit einem zweiten Substrat 21 zusammengefügt. Das zweite Substrat 21, das zum Beispiel eine Halbleiterscheibe aus einkristallinem Silizium oder einem III-V-Halbleiter oder ein vereinzelter Halbleiterchip aus einer solchen Halbleiterscheibe ist, umfaßt Schaltungsstrukturen, die Bestandteil einer mikroelektronischen Schaltung oder einer optoelektronischen Komponente oder einer Sensorkomponente sind. Die Schaltungsstrukturen, die im einzelnen in Figur 2 nicht dargestellt sind, umfassen mindestens eine Metallisierungsebene 22, die durch eine SiO₂-Schicht 23 gegenüber dem zweiten Substrat 21 isoliert ist.

Im Bereich einer zweiten Hauptfläche 24 umfaßt das zweite Substrat 21 Metallstrukturen 28 und isolierende Strukturen 26. Zu den elektrisch leitfähigen Strukturen 28 gehören Metallflächen 25a, die an der Oberfläche der SiO₂-Schicht 23 angeordnet sind, und Kontakte 25b, die über ein Kontaktloch auf die Metallisierungsebene 22 reichen. Die Metallflächen 25a und die Kontakte 25b werden zum Beispiel aus Nickel gebildet. Die Schichtdicke beträgt ca. 1 bis 1,5 µm und ist so bemessen, daß das gesamte Gallium bei der Bildung der hochschmelzenden intermetallischen Phase aufgebraucht wird.

Das erste Substrat 11 und das zweite Substrat 21 werden so zusammengefügt, daß sich entsprechende Metallflächen 15a und 25a sowie sich entsprechende Kontakte 15b und 25b aufeinandertreffen.

Die Substrate werden im Vakuum (Druck < 1 mbar) bei einer Temperatur im Bereich von 200 bis 300°C mit einem Druck von etwa 1000 Pa zusammengepreßt. Dabei schmilzt das sich auf der Oberfläche der leitfähigen Strukturen 18 des ersten Substrats 11 befindende Gallium 19 und verbindet sich mit den Metallstrukturen 28, die sich im Bereich der zweiten Hauptfläche 24 des zweiten Substrats 21 befinden. Bei der Durchmischung von Gallium 19 und Nickel der Metallstrukturen 28 kommt es zur Ausbildung einer intermetallischen Phase, die einen Schmelzpunkt von 895°C aufweist. Dieser Schmelzpunkt liegt weit über der Bearbeitungstemperatur von maximal 450°C, so daß die intermetallische Phase sich verfestigt und zu einer festen Verbindung der beiden Substrate führt.

Da das Gallium 19 selektiv auf der Oberfläche der elektrisch leitfähigen Strukturen 18 abgeschieden wird und da die Metallstrukturen 28 auf die elektrisch leitfähigen Strukturen 18 treffen, wird ein Kurzschluß zwischen benachbarten Metallflächen 15a, 25a und Kontakten 15b, 25b wirksam vermieden. Darüber hinaus wird durch die selektive Abscheidung des Galliums 19 eine hohe Gleichmäßigkeit der Schichtdicke des Galliums 19 erzielt. Bei der Abscheidung des Galliums 19 wird eine Gleichmäßigkeit der Schichtdicke von ± 5 Prozent erzielt.

Die Metallstrukturen 28 können alternativ zu Nickel auch aus Kupfer gebildet werden.

## Patentansprüche

1. Verfahren zur Befestigung eines ersten Substrates auf einem zweiten Substrat,
- bei dem das erste Substrat (11) im Bereich einer ersten Hauptfläche (14) elektrisch leitfähige Strukturen (18) und isolierende Strukturen (16) aus dielektrischem Material umfasst,
- bei dem durch Abscheidung aus der Gasphase unter Verwendung einer metallorganischen Verbindung selektiv auf der Oberfläche der elektrisch leitfähigen Strukturen (18) Gallium (19) abgeschieden wird,
- bei dem das erste Substrat (11) so mit dem zweiten Substrat (21) zusammengefügt wird, dass die erste Hauptfläche (14) des ersten Substrates (11) an eine zweite Hauptfläche (24) des zweiten Substrats (21) angrenzt,
- bei dem auf der zweiten Hauptfläche (24) des zweiten Substrates (21) vor dem Zusammenfügen der Substrate (11, 21) Metallstrukturen (28) aus einem Metall erzeugt werden, das mit Gallium eine intermetallische Phase bildet, die einen Schmelzpunkt oberhalb des Schmelzpunktes von reinem Gallium sowie dem reinen Metall aufweist und die eine feste Verbindung zwischen den Substraten (11, 21) bildet, wobei die Anordnung der Metallstrukturen (28) auf dem zweiten Substrat (21) der Anordnung der elektrisch leitfähigen Strukturen (18) auf dem ersten Substrat (11) entspricht, und
- bei dem beim Zusammenfügen die Metallstrukturen (28) auf die mit Gallium (19) bedeckten elektrisch leitfähigen Strukturen (18) treffen, wobei es durch Durchmischung des Galliums mit dem Metall zur Ausbildung der intermetallischen Phase kommt.

2. Verfahren nach Anspruch 1,
bei dem als metallorganische Verbindung Trialkylgallium mit der chemischen Formel Ga(CₙH₂ₙ₊₁)₃, wobei n eine ganze Zahl größer Null ist, verwendet wird.

3. Verfahren nach Anspruch 1,
bei dem die selektive Abscheidung von Gallium unter Verwendung von Dimethylgalliumhydrid mit der chemischen Formel Ga(CH₃)₂H und H₂ erfolgt.

4. Verfahren nach Anspruch 3,
bei dem das für die selektive Abscheidung erforderliche H₂ durch eine Oberflächenbehandlung mit wässriger Flusssäure (HF:H₂O) und destilliertem Wasser vor der Abscheidung als Oberflächenbelegung auf die erste Hauptfläche (14) aufgebracht wird.

5. Verfahren nach einem der Ansprüche 1 bis 4,
bei dem das Metall mindestens eines der Elemente Nickel oder Kupfer enthält.

6. Verfahren nach einem der Ansprüche 1 bis 5,
bei dem die elektrisch leitfähigen Strukturen (18) mindestens an der Oberfläche Nickel oder Kupfer umfassen.

7. Verfahren nach einem der Ansprüche 1 bis 6,
- bei dem das erste Substrat (11) und das zweite Substrat (21) jeweils Schaltungsstrukturen mit Kontakten (15b, 25b) umfassen,
- bei dem die elektrisch leitfähigen Strukturen (18) mit Kontakten (15b) von Schaltungsstrukturen im ersten Substrat (11) elektrisch verbunden sind,
- bei dem die Metallstrukturen (28) mit Kontakten (25b) im zweiten Substrat (21) elektrisch verbunden sind,
- bei dem über die intermetallische Phase neben einer festen mechanischen Verbindung zwischen den beiden Substraten (11, 21) eine elektrische Verbindung zwischen Schaltungsstrukturen in den beiden Substraten (11, 21) realisiert wird.

8. Verfahren zur Herstellung einer dreidimensionalen Schaltungsanordnung unter Verwendung eines Verfahrens nach einem der Ansprüche 1 bis 7,
- bei dem mehrere Substrate, die im Bereich einer Oberseite Schaltungsstrukturen umfassen und die von der Rückseite her gedünnt werden, als Stapel zusammengefügt und fest miteinander verbunden werden,
- bei dem in den Substraten Kontakte zu den Schaltungsstrukturen gebildet werden, die an die Oberseite und an die Rückseite der Substrate angrenzen und von Isolationsstrukturen umgeben sind,
- bei dem benachbarte Substrate jeweils durch Bildung einer festen Verbindung, die bei der Durchmischung von selektiv auf elektrisch leitenden Strukturen abgeschiedenem Gallium und dem Metall entsteht, verbunden werden, wobei auch aufeinandertreffende Kontakte elektrisch und mechanisch miteinander verbunden werden.

9. Verfahren nach Anspruch 8,
bei dem die Substrate an der Oberseite und/oder Rückseite mit Metallflächen versehen werden, die zusätzliche elektrisch leitfähige Strukturen bilden, die außerhalb der Kontakte angeordnet sind und die gegenüber den Kontakten durch Isolationsstrukturen (26) isoliert sind.

## Claims

1. Method for joining a first substrate to a second substrate,
- in the case of which the first substrate (11) in the area of a first main face (14) comprises electrically conductive structures (18) and insulating structures (16) made from dielectric material,
- in the case of which by precipitation from the gas phase using a organic metal compound gallium (19) is selectively deposited on the surface of the electrically conductive structures (18)
- in the case of which the first substrate (11) is combined with the second substrate (21), so that the first main face (14) of the first substrate (11) is contiguous with a second main face (24) of the second substrate (21),
- in the case of which on the second main face (24) of the second substrate (21) before the substrates (11, 21) are combined, metal structures (28) are produced from a metal, which with gallium forms an inter-metallic phase, which has a melting point above the melting point of pure gallium as well as the pure metal and which forms a solid connection between the substrates (11, 21), whereby the arrangement of the metal structures (28) on the second substrate (21) corresponds to the arrangement of the electrically conductive structures (18) on the first substrate (11), and
- in the case of which when the metal structures (28) are combined they meet the electrically conductive structures (18) coated with gallium (19), whereby as a result of thorough mixing of the gallium with the metal the inter-metallic phase is formed.

2. Method according to Claim 1,
- in the case of which trialkyl gallium with the chemical formula Ga (CₙH₂ₙ₊₁)₃, whereby n is a whole number greater than zero, is used as organic metal compound.

3. Method according to Claim 1,
- in the case of which the selective deposition of gallium takes place using dimethyl gallium hydride with the chemical formula Ga (CH₃)₂H and H₂.

4. Method according to Claim 3,
- in the case of which the H₂ required for selective deposition is applied as a surface coating on the first main face (14) by surface treatment with aqueous hydrofluoric acid (HF:H₂O) and distilled water before deposition.

5. Method according to one of Claims 1 to 4,
- in the case of which the metal contains at least one of the elements nickel or copper.

6. Method according to one of Claims 1 to 5,
- in the case of which the electrically conductive structures (18) at least on the surface comprise nickel or copper.

7. Method according to one of Claims 1 to 6,
- in the case of which the first substrate (11) and the second substrate (21) in each case comprise circuit structures with contacts (15b,25b),
- in the case of which the electrically conductive structures (18) are electrically connected with contacts (15b) of circuit structures in the first substrate (11),
- in the case of which the metal structures (28) are electrically connected with contacts (25b) in the second substrate (21),
- in the case of which electrical connection is realized between the circuit structures in the two substrates (11, 21) via the inter-metallic phase, as well as firm mechanical connection between the two substrates (11, 21)

8. Method to manufacture a three-dimensional circuit arrangement using a method according to one of Claims 1 to 7,
- in the case of which several substrates, which comprise circuit structures in the area of an upper side and which are thinly ground from the rear side, are stacked on top of each other and firmly connected with one another,
- in the case of which in the substrates contacts to the circuit structures are formed, which are contiguous on the upper side and rear side of the substrates and are surrounded by insulation structures,
- in the case of which neighbouring substrates in each case are joined by the formation of a firm connection, which arises during the thorough mixing of gallium selectively deposited on electrically conductive structures and the metal, whereby contacts meeting each other are also electrically and mechanically connected with one another.

9. Method according to Claim 8,
- in the case of which the substrates on the upper side and/or rear side are provided with metal faces, which form additional electrically conductive structures, which are arranged outside the contacts and which are insulated against the contacts by insulation structures (26).

## Revendications

1. Procédé de fixation d'un premier substrat sur un deuxième substrat :
- dans lequel le premier substrat (11) comprend dans la zone d'une première surface principale (14), des structures conductrices de l'électricité (18) et des structures isolantes (16) en un matériau diélectrique,
- dans lequel on dépose du gallium (19) sélectivement sur la surface des structures conductrices de l'électricité (18), par précipitation à partir de la phase gazeuse en utilisant un composé organométallique,
- dans lequel le premier substrat (11) est assemblé au deuxième substrat (21) de sorte que la première surface principale (14) du premier substrat (11) soit contiguë à une deuxième surface principale (24) du deuxième substrat (21),
- dans lequel on produit des structures métalliques (28) à partir d'un métal, sur la deuxième surface principale (24) du deuxième substrat (21) avant l'assemblage des substrats (11, 21), lequel métal forme une phase intermétallique avec le gallium, laquelle présente un point de fusion supérieur au point de fusion du gallium pur ainsi que du métal pur et qui forme une liaison solide entre les substrats (11, 21), où la disposition des structures métalliques (28) sur le deuxième substrat (21) correspond à la disposition des structures conductrices de l'électricité (18) sur le premier substrat (11), et
- dans lequel lors de l'assemblage, les structures métalliques (28) rencontrent les structures (18) conductrices de l'électricité couvertes de gallium (19), où on arrive par le mélange du gallium avec le métal, à la formation de la phase intermétallique.

2. Procédé selon la revendication 1, dans lequel on utilise comme composé organométallique, un trialkylgallium avec la formule chimique Ga(CₙH₂ₙ₊₁)₃, où n est un nombre entier supérieur à 0.

3. Procédé selon la revendication 1, dans lequel la précipitation sélective du gallium est réalisée en utilisant de l'hydrure de diméthylgallium avec la formule chimique Ga(CH₃)₂H et H₂.

4. Procédé selon la revendication 3, dans lequel le H₂ nécessaire pour la précipitation sélective est appliqué sur la première surface principale (14) par un traitement de surface avec de l'acide fluorhydrique aqueux (HF:H₂O) et de l'eau distillée avant la précipitation, comme revêtement de surface.

5. Procédé selon l'une quelconque des revendications 1 à 4, dans lequel le métal contient au moins l'un des éléments nickel ou cuivre.

6. Procédé selon l'une quelconque des revendications 1 à 5, dans lequel les structures conductrices de l'électricité (18) comprennent du nickel où du cuivre au moins en surface.

7. Procédé selon l'une quelconque des revendications 1 à 6,
- dans lequel le premier substrat (11) et le deuxième substrat (21) comprennent chaque fois, des structures de couplage avec contacts (15b, 25b),
- dans lequel les structures conductrices de l'électricité (18) sont reliées électriquement aux contacts (15b) des structures de couplage dans le premier substrat (11),
- dans lequel les structures métalliques (28) sont reliées électriquement aux contacts (25b) dans le deuxième substrat (21),
- dans lequel on réalise par la phase intermétallique, en plus d'une liaison mécanique solide entre les deux substrats (11, 21), une liaison électrique entre les structures de couplage dans les deux substrats (11, 21).

8. Procédé de préparation d'une disposition de couplage en trois dimensions en utilisant un procédé selon l'une quelconque des revendications 1 à 7,
- dans lequel plusieurs substrats, qui comprennent dans la zone d'une face supérieure, des structures de couplage et qui sont amincis sur la face arrière, sont assemblés en piles et reliés solidement les uns aux autres,
- dans lequel des contacts sont formés dans les substrats sur les structures de couplage, qui sont contiguës à la face supérieure et à la face arrière du substrat et sont entourés de structures d'isolation,
- dans lequel les substrats voisins sont chaque fois reliés par formation d'une liaison solide, qui se forme par le mélange du gallium précipitant sélectivement sur les structures conductrices de l'électricité et du métal, moyennant quoi également, les contacts se rencontrant l'un l'autre sont reliés de manière électrique et mécanique.

9. Procédé selon la revendication 8, **caractérisé en ce que** les substrats sont munis de surfaces métalliques sur la face supérieure et/ou la face arrière, lesquelles forment des structures supplémentaires conductrices de l'électricité, qui sont disposées en dehors des contacts et sont isolées par rapport aux contacts par des structures d'isolation (26).
